# EUROPÄISCHE PATENTSCHRIFT

(11) **EP 1 636 486 B1**
(45) Veröffentlichungstag und Bekanntmachung des Hinweises auf die Patenterteilung: **03.11.2010**
(21) Anmeldenummer: 04721814.4
(22) Anmeldetag: 19.03.2004
(51) Int. Cl.: F02M 59/46, F02M 61/16, F02M 47/02, F02M 63/02, F16F 1/02, H01L 41/053, F02M 51/06

(54) **AKTOREINHEIT FÜR EIN PIEZOGESTEUERTES KRAFTSTOFFEINSPRITZVENTIL**
ACTUATING UNIT FOR A PIEZO-ELECTRICALLY CONTROLLED FUEL INJECTION VALVE
UNITE ACTIONNEUR POUR SOUPAPE D'INJECTION DE CARBURANT A COMMANDE PIEZO-ELECTRIQUE

(30) Priorität: 02.05.2003 DE 10319600
(43) Veröffentlichungstag der Anmeldung: 22.03.2006
(73) Patentinhaber: ROBERT BOSCH GMBH, 70442 Stuttgart (DE)
(72) Erfinder: KIENZLER, Dieter, 71229 Leonberg (DE); UHLMANN, Dietmar, 71404 Korb (DE)
(86) Internationale Anmeldenummer: PCT/DE2004/000565
(87) Internationale Veröffentlichungsnummer: WO 2004/097208

(56) Entgegenhaltungen:
- WO-A-00/08353
- WO-A-03/033933
- DE-A- 10 127 583
- DE-A- 10 140 196
- FR-A- 2 257 822
- US-A- 4 958 101
- US-A1- 2003 034 594

## Beschreibung

### Stand der Technik

Die Erfindung betrifft eine Aktoreinheit bestehend aus einem piezoelektrischen Aktor. Solche Aktoreinheiten werden unter anderem bei Kraftstoffeinspritzsystemen und insbesondere in Kraftstoffeinspritzventilen eingesetzt, da die Schaltzeiten solcher Aktoreinheiten sehr kurz sind. Die kurzen Schaltzeiten erlauben einer exaktere Bemessung der eingespritzten Kraftstoffmenge und ermöglichen eine verbesserte Formung des zeitlichen Verlaufs der Einspritzung. Unter dem Sammelbegriff "Kraftstoffeinspritzventil" werden im Zusammenhang mit der Erfindung sämtliche Bauarten von Kraftstoffeinspritzventil, wie zum Beispiel Injektoren für Common-Rail-Einspritzsysteme oder Einspritzdüsen konventioneller Kraftstoffeinspritzanlagen verstanden.

Betätigt wird ein Kraftstoffeinspritzventil mit Piezo-Aktor dadurch, dass der piezoelektrische Aktor mit einer elektrischen Spannung beaufschlagt wird, wodurch sich der piezoelektrische Aktor aufgrund bekannter physikalischer Effekte der Piezokeramik schnell ausdehnt und ein Ventilschließglied von einem Ventilsitz abhebt. Der piezoelektrische Aktor hat eine gewisse Masse, die dabei beschleunigt wird. Wird die an den Aktor angelegte Spannung reduziert, hat der Aktor das Bestreben, sich zusammenzuziehen. Aufgrund der Massenträgheit der zuvor beschleunigten Masse des Aktors entstehen dadurch in Abhängigkeit der Ansteuergeschwindigkeit Zugkräfte im Aktor, die zu Beschädigungen des piezoelektrischen Aktors, insbesondere zu Rissen in den Lötverbindungen zwischen den einzelnen Schichten des piezoelektrischen Aktors, führen. Um derartige Beschädigungen zu vermeiden, ist man dazu übergegangen, den piezoelektrischen Aktor mittels eines als Feder ausgebildeten zylindrischen Hohlkörpers in axialer Richtung vorzuspannen. Eine solche Anordnung ist beispielsweise aus der WO 00/08353 (Siemens) bekannt. Dieser Hohlkörper ist aus einem ebenen Blech gebogen und wird an der dabei entstehenden ersten Fuge verschweißt. Die erste Fuge verläuft dabei parallel zur Längsachse des Hohlkörpers.

FR 2 257 822 A offenbart einen als Feder ausgebildeten Hohlkörper mit variabler Federsteifigkeit.

Das Verschweißen der ersten Fuge hat unter anderem folgende Nachteile: Das Schweißen verursacht eine in der Regel unerwünschte Gefügeveränderung des Hohlkörpers in unmittelbarer Nähe der Schweißnaht. Ein zweites Problem sind die beim Schweißen entstehenden Schweißspritzer, welche Schwierigkeiten bei der Montage der Aktoreinheit mit sich bringen können oder sogar zu Funktionsausfällen des Kraftstoffeinspritzventils führen können, wenn sich während des Betriebs einer oder mehrere Schweißspritzer lösen. Ein drittes Problem ist das Einsinken der Schweißnaht (Nahteinfall) an Beginn und Ende der Schweißaht und die daraus resultierenden Kerbwirkung und Spannungsspitzen.

### Vorteile der Erfindung

Bei der erfindungsgemäßen Aktoreinheit mit einem Hohlkörper und mit einem piezoelektrischer Aktor, wobei der Hohlkörper elastisch ausgebildet ist und den Aktor vorspannt, wobei der Hohlkörper mit Ausnehmungen versehen ist und eine parallel zu der Längsachse verlaufende Fuge aufweist, wobei zwischen zwei benachbarten Ausnehmungen ein Steg vorhanden ist, und wobei der Hohlkörper ein erstes Ende und ein zweites Ende aufweist, ist erfindungsgemäß vorgesehen, dass die zu der Fuge benachbarten Ausnehmungen kleiner als die übrigen Ausnehmungen sind.

Alternativ kann erfindungsgemäß auch vorgesehen sein, dass der Steg zwischen einer zu der Fuge benachbarten Ausnehmung und einer zu dieser Ausnehmung benachbarten Ausnehmung weiter als die Stege zwischen den übrigen Ausnehmungen ist.

Ein Nachteil der Aktoreinheiten mit Hohlkörpern, deren Fuge nicht verschlossen ist, besteht darin, dass die Federsteifigkeit in axialer Richtung nicht über den Umfang konstant ist. In der Regel ist die Federsteifigkeit des Hohlkörpers im Bereich der Fuge reduziert. Im Ergebnis führt dies dazu, dass der Hohlkörper Kräfte in axialer und radialer Richtung sowie Biegemomente in den piezolektrischen Aktor einleitet. Daraus resultiert eine ungleiche Belastung des piezoelektrischer Aktors mit Kräften und Biegemomenten, die unerwünscht ist.

Durch die erfindungsgemäßen Lösungen, die darin bestehen können, die zu der Fuge benachbarten Ausnehmungen kleiner als die übrigen Ausnehmungen der Platine auszuführen--und/oder die Stege im Bereich der Fuge breiter als in der übrigen Platine auszuführen, wird der Hohlkörper in den Bereichen, die sich in unmittelbarer Nachbarschaft zu der Fuge befinden, gezielt verstärkt, so dass die Verringerung der Federrate im Bereich der Fuge kompensiert wird. Dadurch ist es möglich, die Federrate des Hohlkörpers über seinen gesamten Umfang konstant beziehungsweise rotationssymmetrisch zu gestalten, so dass der mit der Federkraft des Hohlkörpers beaufschlagte Piezoaktor nur in axialer Richtung mit Kräften belastet wird und nicht mit Querkräften oder Biegemomenten belastet wird. Dadurch kann die Lebensdauer der mit einem erfindungsgemäßen Hohlkörper ausgerüsteten Aktoreinheiten deutlich gesteigert werden. Es hat sich als vorteilhaft erwiesen, wenn das Verhältnis der Breite eines Steges zwischen einer zu der Fuge benachbarten Ausnehmung zu der Breite der übrigen Stege der Platine einen Wert zwischen 1,3 und 1,9, bevorzugt 1,6, hat. Dies bedeutet, dass die Stege in unmittelbarer Nähe der Fuge um einen Faktor von beispielsweise 1,6 breiter sind als die übrigen Stege der Platine.

In besonders gelagerten Fällen kann es auch hilfreich sein, die Breite der Stege belastungsabhängig zu bemessen, wobei sich die Breite der Stege um bis zu einen Faktor 3 voneinander unterscheiden kann.

Die Ausnehmungen werden in der Platine vorteilhafterweise so angeordnet, dass sie, wenn die Platine zu einem Hohlkörper geformt wurde, in Ebenen angeordnet sind und die Ebenen parallel zueinander verlaufen. Dadurch wird das Verhalten des Hohlkörpers verbessert und dessen Herstellung vereinfacht.

Besonders vorteilhaft ist es, wenn in axialer Richtung eine ungerade Zahl von Ebenen, in denen die Ausnehmungen angeordnet sind, vorgesehen ist. Bei in der Praxis erprobten Ausführungsbeispielen waren beispielsweise 15 oder 17 Ebenen vorteilhaft. Wenn eine ungerade Zahl von Ebenen in der Platine vorhanden ist, ist gewährleistet, dass sowohl die oberste Ebene als auch die unterste Ebene gleich sind und somit das Verhalten des Hohlkörpers an seinem oberen Ende gleich ist wie das Verhalten des Hohlkörpers an seinem unteren Ende. Auch diese Maßnahme verbessert das Verhalten des Hohlkörpers dahingehend, dass der Hohlkörper lediglich Federkräfte in axialer Richtung an seinen Stirnflächen auf den piezoelektrischer Aktor, einen Übersetzungskolben eines hydraulischen Kopplers oder andere Bauelemente des Injektors überträgt.

Es hat sich weiter als vorteilhaft erwiesen, wenn mehrere Ausnehmungen in einer Ebene hintereinander angeordnet sind, und dass diese Ebene mit der Längsachse des Hohlkörpers einen rechten Winkel bildet. Besonders vorteilhaft ist es dabei, wenn eine gerade Zahl von Ausnehmungen in einer Ebene vorhanden ist. Diese Anordnung führt dazu, dass die Federrate über den Umfang des Hohlkörpers konstant ist und somit keine Querkräfte in den Aktor eingeleitet werden.

Es hat sich aus Gründen der Herstellung und der Dauerfestigkeit des Hohlkörpers als günstig erwiesen, wenn die Ausnehmungen knochenförmig ausgebildet sind und quer zu einer Längsachse des Hohlkörpers verlaufen.

Die "knochenförmige" Geometrie der Ausnehmungen kann dadurch beschrieben werden, dass die Ausnehmungen aus einem Mittelstück und zwei Kopfstücken zusammengesetzt sind, dass die Kopfstücke mindestens einen ersten Radius aufweisen, dass das Mittelstück einen zweiten Radius aufweist, und dass die Ausnehmungen eine Länge aufweisen. In verschiedenen Untersuchungen haben sich verschiedene Größenverhältnisse der wichtigsten Maße erster Radius (R₁), zweiter Radius (R₂), Länge (L) sowie die Breite des Steges an der Fuge im Verhältnis zur Breite der übrigen Stege als günstig herausgestellt:
Bei einer günstigen Ausführungsform ist der Radius R₁ einer Ausnehmung, die benachbart zu der Fuge angeordnet ist, um den Faktor 0,867 kleiner als der Radius R₁ der übrigen Ausnehmungen. Des Weiteren ist der zweite Radius R₂ einer benachbart zu der Fuge angeordneten Ausnehmung um den Faktor 1,317 größer als der Radius R₂ der übrigen Ausnehmungen der Platine. Des Weiteren ist die Länge einer benachbart zu der Fuge angeordneten Ausnehmung um den Faktor 0,984 kleiner als die Länge der übrigen Ausnehmungen. Für die Breite des Stegs an der Fuge gilt b > a/2; insbesondere b = 1,4 · a/2. Die detaillierte Erläuterung der verwandten Größen, insbesondere der Größen "a" und "b" wird nachfolgend anhand der Figuren erfolgen.

Des Weiteren hat es sich bei einem anderen Ausführungsbeispiel als vorteilhaft erwiesen, wenn die benachbart zur Fuge angeordneten Ausnehmungen folgende Abmessungen haben:
R₁ = 0,35 mm - 0,43 mm, insbesondere 0,39 mm
R₂ = 4, mm - 8,9 mm, insbesondere 5,0 mm oder 7,9 mm
L = 3,5 mm - 4,5 mm, insbesondere 4,0 mm.

Bei einer anderen Ausführungsform haben die benachbart zur Fuge angeordneten Ausnehmungen folgende Abmessungen:
R₁ = 0,41 mm - 0,49 mm, insbesondere 0,45 mm
R₂ = 5,5 mm - 6,5 mm, insbesondere 6,0 mm
L = 3,7 mm - 4,7 mm, insbesondere 4,2 mm.

Für die übrigen Ausnehmungen, die nicht benachbart zu der Fuge angeordnet sind, haben sich folgende Abmessungen als günstig herausgestellt:
R₁ = 0,43 mm - 0,51 mm, insbesondere 0,47 mm
R₂ = 4,0 mm - 4,8 mm, insbesondere 4,4 mm
L = 4,5 mm - 5,5 mm, insbesondere 5,0 mm.

Bei einem weiteren vorteilhaften Ausführungsbeispiel haben die Ausnehmungen welche nicht benachbart zur Fuge angeordnet sind, folgende Abmessungen:
R₁ = 0,4 mm - 0,5 mm, insbesondere 0,45 mm
R₂ = 5,5 mm - 6,5 mm, insbesondere 6,0 mm
L = 4,0 mm - 4,5 mm, insbesondere 4,255 mm.

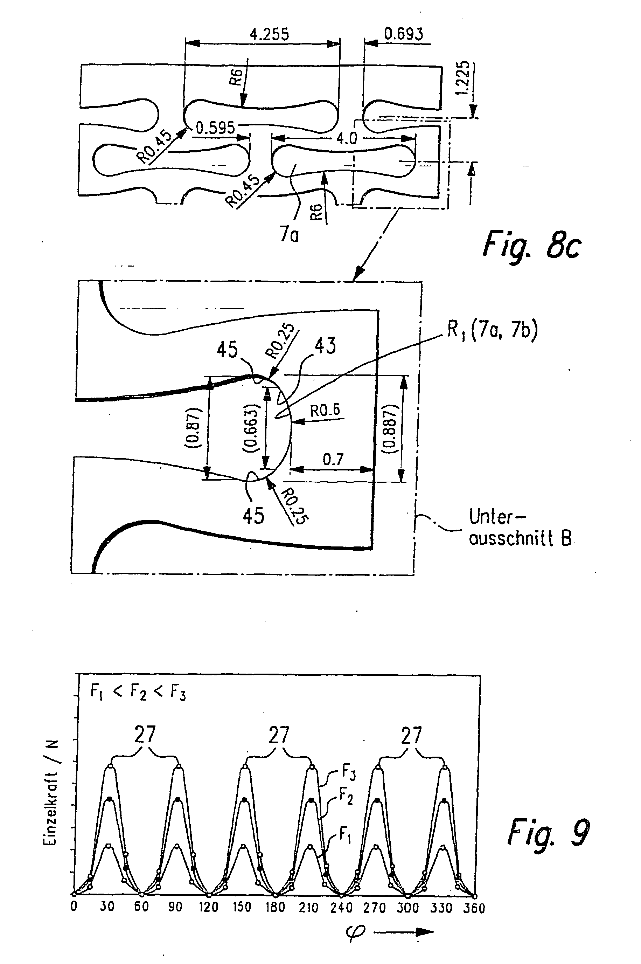

Es hat sich auch als vorteilhaft erwiesen, wenn die ersten Radien der Kopfstücke einer benachbart zu der Fuge angeordneten Ausnehmung voneinander verschieden sind, wie dies beispielhaft nachfolgend anhand der Figur 8c erläutert werden wird.

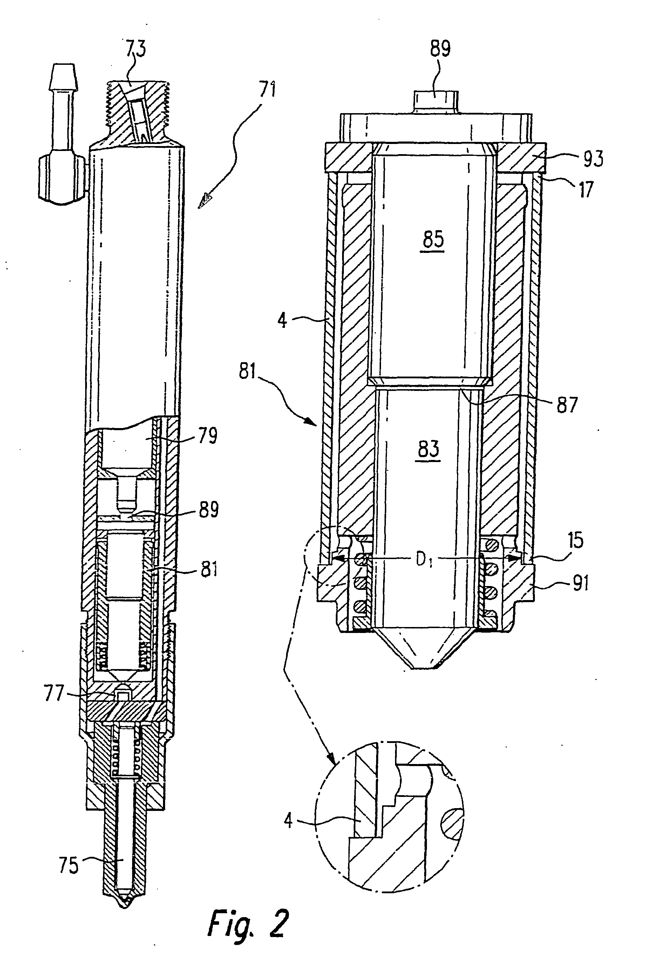

Es ist weiterhin vorteilhaft, wenn die Ausnehmungen zweier benachbarter Ebenen zueinander versetzt angeordnet sind. Besonders vorteilhaft ist es dabei, wenn der Versatz der Ausnehmungen zweiter benachbarter Ebenen gleich dem halben Rapport der Ausnehmungen einer Ebene ist. Der Begriff "Rapport" wird weiter unten im Zusammenhang mit der Figur 2 noch ausführlich erläutert werden. Es ist besonders vorteilhaft, wenn der Hohlkörper einen kreisrunden Querschnitt oder der Querschnitt des Hohlkörpers die Form eines regelmäßigen Vielecks hat.

Erfindungsgemäß kann weiter vorgesehen sein, dass der Hohlkörper an seinem ersten Ende und/oder an seinem zweiten Ende einen nicht durch Ausnehmungen perforierten Bereich aufweist. Dadurch wird die vom Hohlkörper auf eine Abdeckplatte oder ein anderes Bauteil des Injektors übertragene Federkraft vergleichsmäßig, da der Hohlkörper im Bereich seiner Enden gezielt versteift wird. Dies bedeutet, dass sich die Maxima der Federkraft über den Umfang des Hohlkörpers verringern und die Problematik der von dem Hohlkörper in den Piezoaktor eingeleiteten Querkräfte weiter entschärft wird.

Der erfindungsgemäße Hohlkörper kann bei Aktoreinheiten eingesetzt werden, in denen der piezoelektrischer Aktor im Hohlkörper angeordnet ist und bei denen der piezoelektrischer Aktor durch den vorgespannten Hohlkörper auf Druck belastet wird. Dies bedeutet, dass der Hohlkörper selbst auf Zug belastet wird.

Der erfindungsgemäße Hohlkörper kann aber ebenfalls an Aktoreinheiten eingesetzt werden, bei denen der piezoelektrischer Aktor außerhalb des Hohlkörpers angeordnet ist und der piezoelektrischer Aktor durch den vorgespannten Hohlkörper auf Druck belastet wird. In diesem Fall wird der Hohlkörper in der Regel auf Druck belastet.

Um die Vorspannkraft von dem Hohlkörper auf den piezoelektrischen Aktor bestmöglich einleiten zu können, empfiehlt es sich, dass der Hohlkörper an seinem ersten Ende mit einer oberen Abdeckplatte oder einer Einstellscheibe und an seinem zweiten Ende mit einer unteren Abdeckplatte oder einem Kopplergehäuse verbunden ist. Diese Verbindungen können beispielsweise durch Schweißen oder Bördeln erfolgen.

Wenn nur eine radiale Fixierung des Hohlkörpers erforderlich ist, kann diese durch eine Ringnut oder einen Absatz in der oberen und/oder der unteren Abdeckplatte oder in der Einstellscheibe und dem Kopplergehäuse erfolgen. Dies kann beispielsweise dann ausreichend sein, wenn der Hohlkörper nicht auf Zug, sondern auf Druck belastet wird. Besonders vorteilhaft an diesen Ausführungsvarianten ist, dass durch die Ringnut und durch den Absatz der Hohlkörper relativ zu dem piezoelektrischen Aktor oder zu dem hydraulischen Koppler zentriert wird. Dieser Effekt kann weiter verbessert werden, wenn Ringnut und Absatz so bemessen werden, dass sie den Hohlkörper bei der Montage geringfügig aufweiten.

Weitere Vorteile und vorteilhafte Ausgestaltungen der Erfindung sind der nachfolgenden Zeichnung, deren Beschreibung und den Patentansprüchen entnehmbar.

### Zeichnungen

Es zeigen:
- Figur 1: ein erstes Ausführungsbeispiel einer erfindungsgemäßen Aktoreinheit,
- Figur 2: ein zweites Ausführungsbeispiel einer erfindungsgemäßen Aktoreinheit,
- Figur 3: ein Beispiel für eine Platine aus der ein Hohlkörper gebogen wird,
- Figur 4: ein erstes Ausführungsbeispiel eines Hohlkörpers in einer perspektivischen Darstellung,
- Figur 5: ein Ausführungsbeispiel einer Platine aus der ein erfindungsgemäßer Hohlkörper gebogen wird,
- Figur 6: ein aus einer Platine gemäß Fig. 5 gebogener Hohlkörper in einer perspektivischen Darstellung,
- Figur 7: ein weiteres Ausführungsbeispiel einer Platine zur Herstellung eines erfindungsgemäßen Hohlkörpers,
- Figur 8: ein weiteres Ausführungsbeispiel einer Platine zur Herstellung eines erfindungsgemäßen Hohlkörpers,
- Figur 9: eine Darstellung der auf einen erfindungsgemäßen Hohlkörper gemäß Fig. 8 übertragbaren Kräfte,
- Figur 10: ein weiteres Ausführungsbeispiel einer Platine zur Herstellung eines erfindungsgemäßen Hohlkörpers,
- Figur 11: eine Darstellung der auf einen erfindungsgemäßen Hohlkörper gemäß Fig. 10 übertragbaren Kräfte,
- Figur 12: ein weiteres Ausführungsbeispiel einer Platine zur Herstellung eines erfindungsgemäßen Hohlkörpers und
- Figur 13: eine schematische Darstellung einer Kraftstoffeinspritzanlage.

### Beschreibung der Ausführungsbeispiele

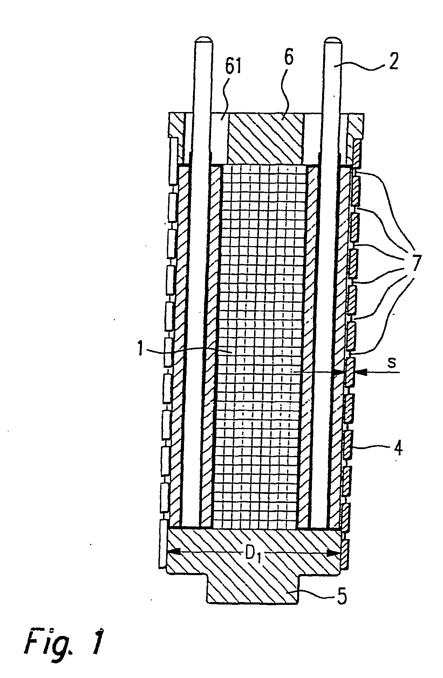

In Figur 1 ist ein erstes Ausführungsbeispiel einer erfindungsgemäßen Aktoreinheit dargestellt. Die Aktoreinheit besteht aus einem piezoelektrischen Aktor 1, der aus mehreren übereinander gestapelten piezoelektrischen Einzelelementen (nicht dargestellt) aufgebaut sein kann. Der piezoelektrische Aktor 1 wird über Kontaktstifte 2 angesteuert, die längs des Aktors 1 angeordnet sind und mit dem Aktor 1 elektrisch leitend verbunden sind. Durch Anlegen einer Spannung zwischen den Kontaktstiften 2 wird eine Längsdehnung des piezoelektrischen Aktors 1 erzeugt, die beispielsweise zum Steuern eines Einspritzventils in einer Brennkraftmaschine eingesetzt werden. Der piezoelektrische Aktor 1 mit den Kontaktstiften 2 ist in einem als Rohrfeder ausgebildeten Hohlkörper 4 angeordnet. Der piezoelektrische Aktor 1 liegt mit seinen Stirnflächen jeweils an einer Abdeckplatte 5, 6 an, wobei die obere Abdeckplatte 6 Durchführungen 61 aufweist, durch die sich die Kontaktstifte 2 erstrecken. Die obere und untere Abdeckplatte 5, 6 sind jeweils form- und/oder kraftschlüssig, vorzugsweise durch Schweißen, mit dem Hohlkörper 4 verbunden. Die Schweißnähte zwischen der oberen und der unteren Abdeckplatte 5, 6 sowie des Hohlkörpers 4 sind in Figur 1 nicht dargestellt. Alternativ kann die Verbindung zwischen dem Hohlkörper und den beiden Abdeckplatten 5, 6 zum Beispiel auch mit Hilfe einer Bördelung erfolgen, wobei die umgebördelten oberen und unteren Randbereiche des Hohlkörpers 4 jeweils in die Abdeckplatten 5, 6 eingreifen (nicht dargestellt).

Der piezoelektrische Aktor 1 wird durch den Hohlkörper 4 und die Abdeckplatten 5, 6 mit einer Vorspannkraft auf Druck beansprucht. D. h. der Hohlkörper 4 wird vor dem Verschweißen mit der oberen und unteren Abdeckplatte 5, 6 vorgespannt und dann verschweißt.

Der Hohlkörper 4 wird vorzugsweise aus Federstahl gefertigt. Um eine gewünschte Federrate bei vorgegebener Wandstärke "s" einstellen zu können, sind in den Hohlkörper 4 eine Vielzahl von Ausnehmungen 7 eingebracht. Aus Gründen der Übersichtlichkeit sind nicht alle Ausnehmungen in Figur 1 mit Bezugszeichen versehen worden. Da sich die vielen Ausnehmungen 7 am besten durch Stanzen herstellen lassen, wird der Hohlkörper 4 in der Regel aus Blech gefertigt. Aus dem Blech wird zunächst eine Platine mit den Ausnehmungen 7 ausgestanzt. Anschließend wird die Platine gebogen, bis sie beispielsweise einen kreisrunden Querschnitt oder einen Querschnitt in Form eines regelmäßigen Vielecks hat. Dort wo die beiden Enden der gebogenen Platine aufeinander treffen, entsteht eine erste Fuge (in Fig. 1 nicht dargestellt).

In Figur 2 wird ein zweites Ausführungsbeispiel einer erfindungsgemäßen Aktoreinheit dargestellt, die in einen piezobetätigten Injektor 71 integriert ist.

Da die vorliegende Erfindung im Wesentlichen eine Aktoreinheit und einen dazugehörigen Hohlkörper 4 betrifft, wird der Injektor 71 nicht in allen Details erläutert, sondern im Wesentlichen nur die Anbindung der Aktoreinheit an den Injektor 71 beschrieben. Die übrigen Funktionalitäten des Injektors 71 sind einem Fachmann auf dem Gebiet der Einspritztechnik ohnehin bekannt und bedürfen deshalb keiner näheren Erläuterung.

Der Injektor 71 hat einen Hochdruckanschluss 73. Über den Hochdruckanschluss 73 wird der Injektor 71 mit unter hohem Druck stehenden Kraftstoff (nicht dargestellt) versorgt. Wenn eine Einspritzung in den nicht dargestellten Brennraum einer Brennkraftmaschine erfolgen soll, hebt eine Düsennadel 75 von ihrem nicht dargestellten Sitz ab und gibt ebenfalls nicht dargestellte Spritzlöcher frei. Gesteuert wird die Düsennadel 75 über ein Steuerventil 77, welches über einen piezoelektrischen Aktor 79 betätigt wird. Zwischen dem piezoelektrischer Aktor 79 und dem Steuerventil 77 ist ein hydraulischer Koppler 81 angeordnet, welcher auf der rechten Seite von Figur 1 vergrößert dargestellt ist.

Der hydraulische Koppler 81 besteht im Wesentlichen aus einem Ventilkolben 83 und einem Übersetzerkolben 85, die in einem Kopplergehäuse 86 geführt werden. Zwischen dem Ventilkolben 83 und dem Übersetzerkolben 85 ist ein Kopplerspalt 87 vorhanden, welcher mit Kraftstoff (nicht dargestellt) gefüllt ist. Dieser Kopplerspalt 87 ist unter anderem deswegen notwendig, weil sich die Temperaturausdehnungskoeffizienten des piezoelektrischen Aktors 79 und der metallischen Bauteile des Injektors 71 stark unterscheiden.

Mit seinem Ventilkolben 83 betätigt der hydraulische Koppler 81 das Steuerventil 77, während der Übersetzerkolben 85 mit einem Vorsprung 89 an den piezoelektrischer Aktor 79 anliegt. Der Übersetzerkolben 85 wird über einen erfindungsgemäßen Hohlkörper 4, welcher auf Druck vorgespannt ist, gegen den piezoelektrischer Aktor 79 gepresst, so dass dieser mit einer Druckvorspannung beaufschlagt wird. Dabei stützt sich der Hohlkörper mit seinem ersten Ende 15 gegen einen Absatz 91 des Kopplergehäuses 86 ab. Mit seinem zweiten Ende 17 stützt sich der Hohlkörper 4 gegen eine Einstellscheibe 93 ab. Über die Einstellscheibe 93 wird die Federkraft des Hohlkörpers 4 auf den Vorsprung 89 des Übersetzerkolbens 85 und damit auf den piezoelektrischen Aktor 79 übertragen.

Damit der Hohlkörper 4 konzentrisch zum hydraulischen Koppler 81 und damit auch konzentrisch zum piezoelektrischen Aktor 79 angeordnet ist, ist der Durchmesser D₁ des Absatzes 91 so auf den Innendurchmesser des Hohlkörpers 4 abgestimmt, dass der Hohlkörper 4 leicht aufgeweitet wird, wenn er auf den Absatz 91 aufgeschoben wird. Da der erfindungsgemäße Hohlkörper 4 eine sich über die gesamte Länge des Hohlkörpers 4 erstreckende erste Fuge 31 (nicht dargestellt) aufweist, lässt sich der Hohlkörper 4 relativ leicht so weit aufweiten, dass er auf den Absatz 91 passt.

Wenn, wie bei dem Ausführungsbeispiel gemäß Figur 1, der Hohlkörper 4 mit einer Druckvorspannung beaufschlagt wird, genügt es, wenn dieser sich an seinen Enden 17 und 15 in axialer Richtung abstützen kann, wie dies in Figur 1 dargestellt ist. Um die radiale Fixierung des Hohlkörper 4 weiter zu verbessern, kann in dem Absatz 91 und/oder in der Einstellscheibe 93 alternativ oder zusätzlich eine Ringnut (nicht dargestellt) vorgesehen sein.

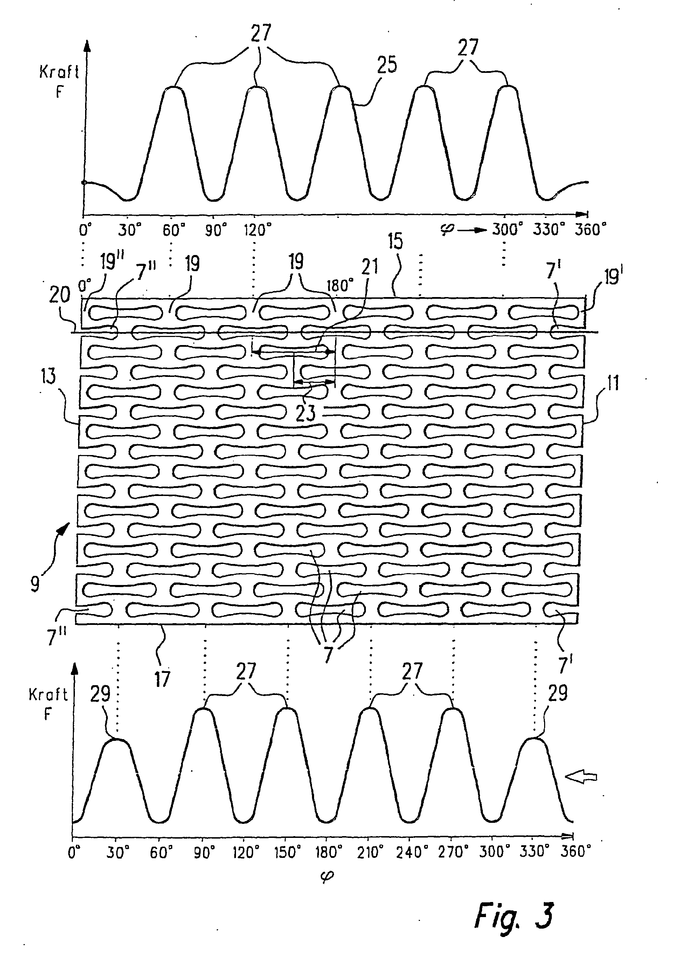

In Figur 3 ist eine Platine 9 dargestellt, aus der ein erfindungsgemäßer Hohlkörper 4 gewickelt werden kann. In der Platine 9 ist eine Vielzahl von Ausnehmungen 7 ausgestanzt. Aus Gründen der Übersichtlichkeit sind nicht alle Ausnehmungen 7, die bei dem in Figur 2 dargestellten Ausführungsbeispiel eine knochenförmige Form haben, mit Bezugszeichen versehen. Die Platine 9 ist rechteckig, wobei zwei einander gegenüberliegende Kanten 11 und 13 der Platine 9 von den Ausnehmungen 7 unterbrochen werden, während die einander gegenüberliegenden Kanten 15 und 17 gerade verlaufen und nicht von den Ausnehmungen 7 unterbrochen werden.

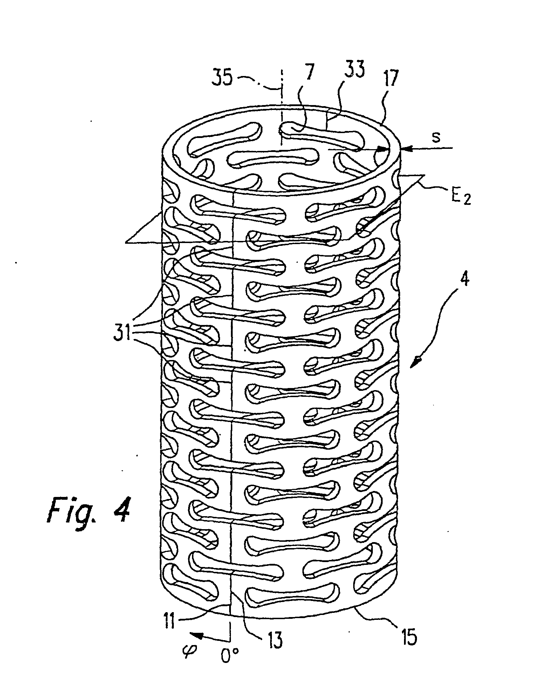

Die Platine 9 wird so zu einem zylindrischen oder vieleckigen Hohlkörper gewickelt, dass die Kanten 15 und 17 das erste Ende 15 und das zweite Ende 17 des Hohlkörpers 4 bilden (siehe Figur 4) bilden. Das heißt, die in Figur 2 nicht dargestellte Längsachse 35 (siehe Fig. 4) des Hohlkörpers 4 verläuft parallel zu den Kanten 11 und 13.

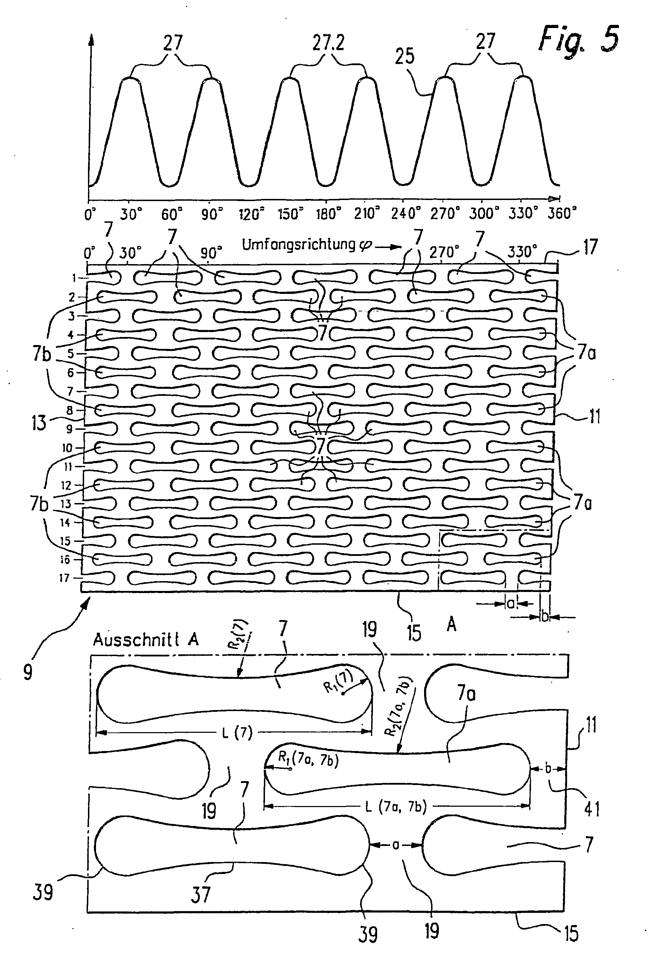

Wenn die Platine 9 in der oben genannten Weise zu einem Zylinder oder einem Vieleck gebogen wurde, berühren sich die Kanten 11 und 13 und bilden eine erste Fuge 31 (siehe Fig. 4 und 5), die parallel zur Längsachse 35 des Hohlkörpers 4 verläuft.

In der Platine 9 sind immer mehrere Ausnehmungen 7 in einer Reihe hintereinander angeordnet. Sie werden durch Stege 19 zwischen den Ausnehmungen getrennt. Auch bei den Stegen 19 wurde darauf verzichtet, alle Stege der Platine 9 mit Bezugszeichen zu versehen, um die Übersichtlichkeit nicht zu beeinträchtigen. Wenn die Platine 9 zu einem Hohlkörper in der zuvor beschriebenen Weise gebogen wird, liegen die hintereinander angeordneten Ausnehmungen 7 in einer Ebene. Beispielhaft ist in Figur 3 eine Reihe von Ausnehmungen 7, die hintereinander angeordnet sind, durch eine Linie 20 gekennzeichnet. Bei dem in Figur 3 dargestellten Ausführungsbeispiel einer Platine 9 sind 16 Reihen von sechs Ausnehmungen 7 zwischen der Kante 15 und der Kante 17 angeordnet.

Wie aus Figur 3 ersichtlich, sind die Ausnehmungen 7 zweier benachbarter Reihen versetzt zueinander angeordnet. Dabei ist der Versatz so gewählt, dass er der halben Länge einer Ausnehmung 7 und eines Stegs 19 entspricht. Dieses Maß ist in der Figur 3 exemplarisch für eine Ausnehmung und zwei halbe Stege 19 durch den Doppelpfeil 21 angedeutet. Dieses Maß wird auch als "Rapport" bezeichnet. Der Versatz zwischen den Ausnehmungen 7 zweier benachbarter Reihen von Ausnehmungen ist in Figur 3 mit dem Bezugszeichen 23 bezeichnet.

Wenn man die Platine 9 zu einem Hohlkörper 4 (siehe Fig. 4) aufrollt und diesen Hohlkörper 4 an seinen Stirnseiten über eine obere Abdeckplatte 5 (siehe Figur 1) und eine untere Abdeckplatte 6 (siehe Figur 1) mit einer Druckkraft beaufschlagt, dann hat die zwischen oberer Abdeckplatte 5 und der Kante 15 wirkende Kraft F über den Umfang des Hohlkörpers 4 den durch die Linie 25 qualitativ dargestellten Verlauf (siehe Figur 5). Der Umfangs-Winkel ϕ beginnt an der Kante 13 mit 0° und endet an der Kante 11 mit 360°.

Es zeigt sich, dass immer dort, wo ein Steg 19 die Kante 15 "abstützt", eine große Kraft F, angedeutet durch die Maxima 27 der Linie 25, übertragen werden kann. Die einzige Ausnahme existiert dort, wo die Kanten 11 und 13 aneinander stoßen. Dort schwächt die "durchgeschnittene" Ausnehmung 7 mit ihren Teilen 7' und 7" die Struktur der Platine 9, so dass die an dieser Stelle zwischen oberer Abdeckplatte 5 und Hohlkörper 4 übertragene Kraft F geringer ist. Dieser Sachverhalt ist in Figur 3 durch den im Vergleich mit den Maxima 27 deutlich geringeren Wert für die Kraft F, bei ϕ = 0° und bei ϕ = 360° dargestellt.

Ähnlich verhält es sich an der Kante 17. Wie aus Figur 3 ersichtlich, befindet sich in unmittelbarer Nähe der Kante 17 bei ϕ = 0° und 360° eine angeschnittene Ausnehmung , bestehend aus den Teilen 7' und 7", während sich in unmittelbarer Nähe der Kante 15 bei ϕ = 0° und 360° ein aufgetrennter Steg 19 mit den Hälften 19' und 19" befindet. Daraus ergibt sich ein etwas anderer Kräfteverlauf über den Umfang der Kante 17.

Es gibt dort, wie aus dem unteren F-ϕ-Diagramm in Figur 3 ersichtlich, vier Maxima 27 und zwei weitere lokale Maxima 29 in der Nähe der Kante 11 und 13 bei den Winkeln ϕ = 30° und 330°, die deutlich kleiner als die Maxima 27 sind.

Wegen dieser über den Umfang ungleichen Kraftübertragung zwischen oberer Abdeckplatte 6 und der Kante 15 einerseits sowie der unteren Abdeckplatte 5 und der Kante 17 andererseits wird ein auf die obere Abdeckplatte 6 und die untere Abdeckplatte 5 wirkendes Biegemoment von dem Hohlkörper 4 erzeugt, wenn der Hohlkörper 4 mit einer Vorspannung an der oberen und der unteren Abdeckplatte 6, 5 befestigt wird. Dieses Biegemoment wird naturgemäß auch auf den piezoelektrischen Aktor 1 übertragen, was sich ungünstig auf dessen Betriebssicherheit und Lebensdauer auswirkt. Außerdem ist dieses Biegemoment auch an den von der Aktoreinheit betätigten hydraulischen Ventilgliedern nicht erwünscht.

In Figur 4 ist ein Hohlkörper 4, der aus einer in Fig. 3 dargestellten Platine 9 hergestellt wurde, perspektivisch dargestellt. Die Reihen von Ausnehmungen 7, die in Figur 4 nicht einzeln bezeichnet sind, bilden 16 Ebenen E₁ bis E₁₆, welche senkrecht zur Längsachse 35 des Hohlkörpers 4 verlaufen. Andeutungsweise ist in Fig. 4 zur Veranschaulichung eine Ebene E₂ dargestellt. Ebenso ist in Fig. 4 die Wandstärke s des Hohlkörpers 4 eingezeichnet.

In Figur 5 wird eine Platine 9 dargestellt, welche zur Herstellung eines erfindungsgemäßen Hohlkörpers 4 benutzt werden kann. Aus der Gesamtansicht der Platine 9 wird deutlich, dass insgesamt 17 Reihen von Ausnehmungen 7 vorgesehen sind. Wenn die Platine 9 zu einem Hohlkörper geformt wird, bilden diese 17 Reihen 17 Ebenen, innerhalb derer die Ausnehmungen 7 angeordnet sind. Die Kanten 11 und 13 bilden bei dem Hohlkörper die Fuge 31. Die Kanten 17 und 15 bilden bei dem fertigen Hohlkörper 4 ein erstes Ende und ein zweites Ende. Deshalb wird im Zusammenhang mit dem fertig gestellten Hohlkörper 4 mit dem Bezugszeichen 17 das erste Ende des Hohlkörpers 4 und mit dem Bezugszeichen 15 das zweite Ende des Hohlkörpers 4 bezeichnet.

Erfindungsgemäß ist bei der Platine 9 vorgesehen, dass die benachbart zu der Fuge 31 und damit zu den Kanten 11 und 13 angeordneten Ausnehmungen 7a und 7b eine gegenüber den übrigen Ausnehmungen 7, von denen nicht alle mit Bezugslinien versehen wurden, geänderte Geometrie haben. Nachfolgend werden anhand des Ausschnittes A aus der Platine 9 die unterschiedlichen Geometrien der Ausnehmungen 7 sowie 7a und 7b näher erläutert. Bei diesem Ausführungsbeispiel haben die Ausnehmungen 7a und 7b die gleiche Geometrie. Wie aus Figur 4 ersichtlich, haben die Ausnehmungen 7, 7a und 7b eine "knochenförmige" Gestalt. Dabei setzt sich jede Ausnehmung 7, 7a, 7b aus einem Mittelstück 37 und zwei daran anschließenden Kopfstücken 39 zusammen. Die Bezugszeichen 37 und 39 sind exemplarisch nur an einer Ausnehmung 7 angebracht worden. Die Kopfstücke 39 lassen sich durch einen ersten Radius R₁ quantitativ beschreiben, während sich die Mittelstücke 37 durch einen zweiten Radius R₂ quantitativ beschreiben lassen. Eine weitere wichtige geometrische Größe der Ausnehmungen 7, 7a und 7b ist die Länge L. Es hat sich nun als vorteilhaft herausgestellt, wenn der erste Radius der Ausnehmungen 7a und 7b um den Faktor 0,867 kleiner ist als der erste Radius der Ausnehmungen 7. Weiter hat es sich als vorteilhaft erwiesen, wenn der zweite Radius R₂ (7a, 7b) der Ausnehmungen 7a und 7b um den Faktor 1,317 größer ist als der zweite Radius R₂ der Ausnehmung 7 und wenn die Länge L der Ausnehmungen 7a und 7b um den Faktor 0,984 kleiner als die Länge der Ausnehmungen 7 ist.

Zwischen zwei Ausnehmungen 7 ist immer ein Steg 19 vorhanden.

Die erste Reihe von Ausnehmungen 7, welche sich in unmittelbarer Nähe der Kante 17 befindet, besteht aus sechs Ausnehmungen 7. Dabei sind die sechs Ausnehmungen 7 der ersten Reihe so angeordnet, dass eine Ausnehmung geteilt ist. Diese Ausnehmung 7 wird durch die Kanten 11 und 13 in zwei symmetrische Hälften unterteilt.

In der zweiten Reihe sind vier Ausnehmungen 7 und jeweils eine Ausnehmung 7a und 7b vorhanden. Dabei sind die Ausnehmungen 7a und 7b so angeordnet, dass sie sich in unmittelbarer Nähe zu den Kanten 11 und 13 befinden. Da die Ausnehmungen 7a und 7b kleiner sind als die Ausnehmungen 7, wird der Hohlkörper 4 bei einem Umfangswinkel ϕ von 30 ° und einem Umfangswinkel ϕ von 330 nämlich dort, wo die Ausnehmungen 7a und 7b die Federrate des Hohlkörpers 4 beeinflussen, versteift. Diese Versteifung im Bereich der Umfangswinkel ϕ = 30 ° und 330 ° kompensiert die Schwächung des Hohlkörpers 4 durch die zwischen den Kanten 11 und 13 befindliche Fuge 31 (siehe Figur 4). Der Erfolg dieser Maßnahme ist an dem oberhalb der Platine 9 dargestellten F-ϕ-Diagramm erkennbar. Im Vergleich zu der Figur 3, wo im Bereich der Umfangswinkel ϕ = 30 ° und 330 ° ein deutliches Absinken der übertragbaren Kraft feststellbar ist, sind in dem F-ϕ-Diagramm in Figur 5 sechs Maxima 27 erkennbar, die alle den gleichen Betrag haben. Dies bedeutet, dass ein aus der Platine 9 gemäß Figur 5 hergestellter Hohlkörper 4 eine über den Umfang seiner Stirnseiten 15 und 17 gleichmäßige Federrate aufweist, so dass die von dem Hohlkörper 4 auf eine obere oder untere Abdeckplatte beziehungsweise einen Absatz 91 oder 93 übertragene Federkraft ausschließlich in axialer Richtung wirkt und keine Querkräfte und keine Biegemomente an den von der Federkraft des Hohlkörpers 4 beaufschlagten Bauteilen verursacht. Damit ist das Ziel der Erfindung durch eine Platine 9 gemäß Figur 5 erreichbar.

Bezüglich der Breite der Stege 19, welche in dem Ausschnitt A mit "a" bezeichnet wird und der Breite "b" der halben Stege 41 zwischen einer Ausnehmung 7a und der Kante 11 beziehungsweise einer Ausnehmung 7b und der 13 hat sich folgender quantitativer Zusammenhang als vorteilhaft herausgestellt. Die Breite b des halben Stegs 41 soll größer sein als a/2, insbesondere soll b = 1,4 · a/2 sein.

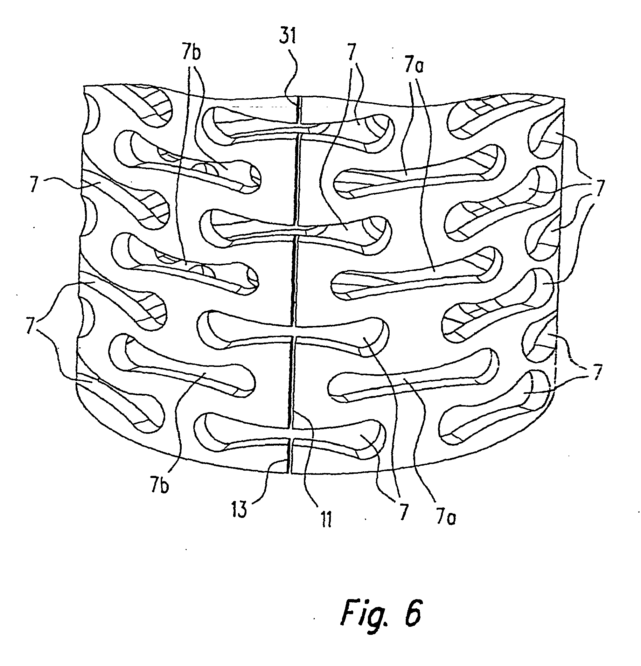

In Figur 6 ist ein erfindungsgemäßer Hohlkörper 4 ausschnittsweise und perspektivisch dargestellt. Aus dieser Darstellung ergibt sich, dass sich die Ausnehmungen 7a und 7b in unmittelbarer Nähe zu der Fuge 31 befinden.

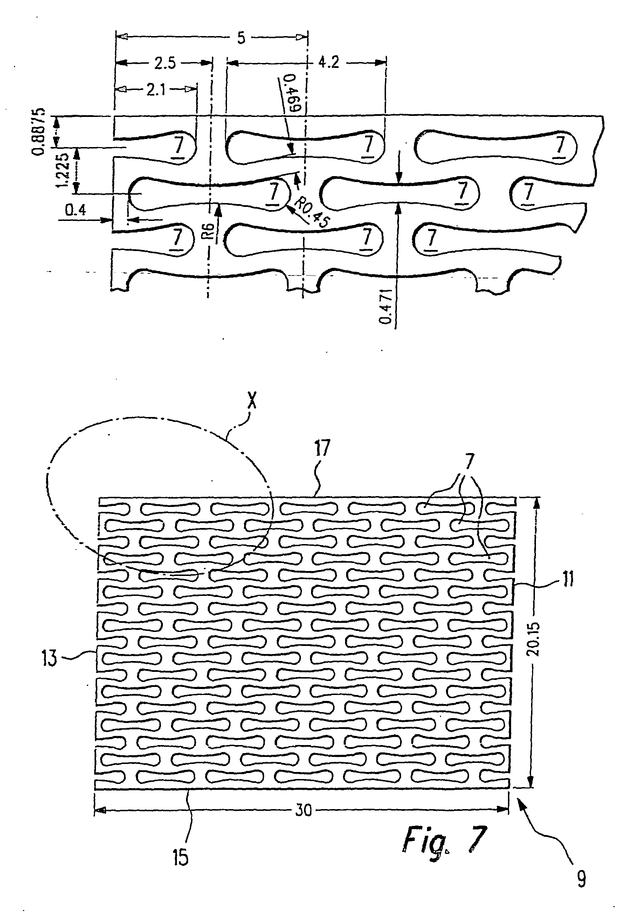

In der Figur 7 sind eine Platine 9 sowie ein Detail der Platine 9 dargestellt, aus der sich die Bemaßung der Ausnehmungen 7 sowie der gesamten Platine ergibt. Diese Platine 9 weist nur Ausnehmungen 7 und keine Ausnehmungen mit dem gegenüber anderer Geometrie (7a und 7b) auf.

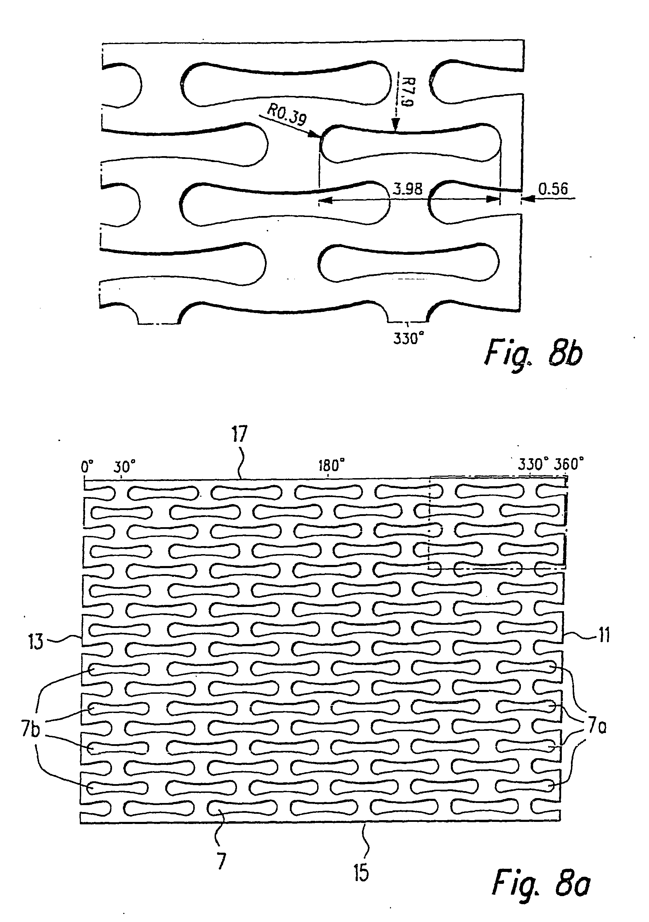

In den Figuren 8a, 8b und 8c sind Platinen 9 beziehungsweise Ausschnitte der Platine 9 mit einer bemaßten Darstellung der zu der Fuge 31 benachbart angeordneten Ausnehmungen 7a und 7b dargestellt. Auch bei diesen Ausführungsbeispielen konnte die der Erfindung zugrunde liegende Aufgabe gelöst werden, welche im Wesentlichen darin besteht, eine querkraftfreie Vorspannung des piezoelektrischer Aktors 1 und 79 in axialer Richtung zu erreichen.

Die in den Figuren 8b und 8c ausschnittsweise dargestellten Ausführungsformen haben sich ebenfalls als vorteilhaft erwiesen. Auf eine detaillierte Erläuterung wird hier verzichtet, da die in den genannten Figuren eingetragene Bemaßung selbtserklärend ist und der prinzipielle Aufbau einer solchen Platine 9 anhand der Figuren 3 und 5 ausführlich erläutert wurde.

Es wird jedoch auf den Unterausschnitt B der Figur 8c hingewiesen. Dabei setzt sich der erste Radius R₁ von den Ausnehmungen 7a und 7b an der den Kanten 11 beziehungsweise 13 (nicht dargestellt) zugewandten Seite aus drei Kreisbogenabschnitten zusammen. In der Mitte ist ein erster Kreisbogenabschnitt 43 mit einem Radius von 0,6 mm vorhanden, an den sich zu beiden Seiten zwei zweite Kreisbogenabschnitte 45 mit einem Radius von 0,25 mm anschließen. Die anhand der Figur 8c in ihrer Geometrie beschriebenen Aussparungen 7a und 7b sind Ausführungsbeispiele für Ausnehmungen, bei denen die ersten Radien der Kopfstücke einer benachbart zu der Fuge angeordneten Ausnehmung 7a oder 7b im Sinne des Anspruchs 7 voneinander verschieden sind.

In der Figur 9 ist ein F-ϕ-Diagramm eines aus einer Platine gemäß Figur 8 hergestellten Hohlkörpers 4 in unterschiedlichen Belastungszuständen dargestellt. Die Belastungszustände werden durch drei Linien, denen drei verschiedene Kräfte F₁, F₂ und F₃ entsprechen, repräsentiert. Es zeigt sich anhand der Figur 9, dass bei verschiedensten Belastungszuständen die Federrate des Hohlkörpers 4 über den Umfang konstant ist.

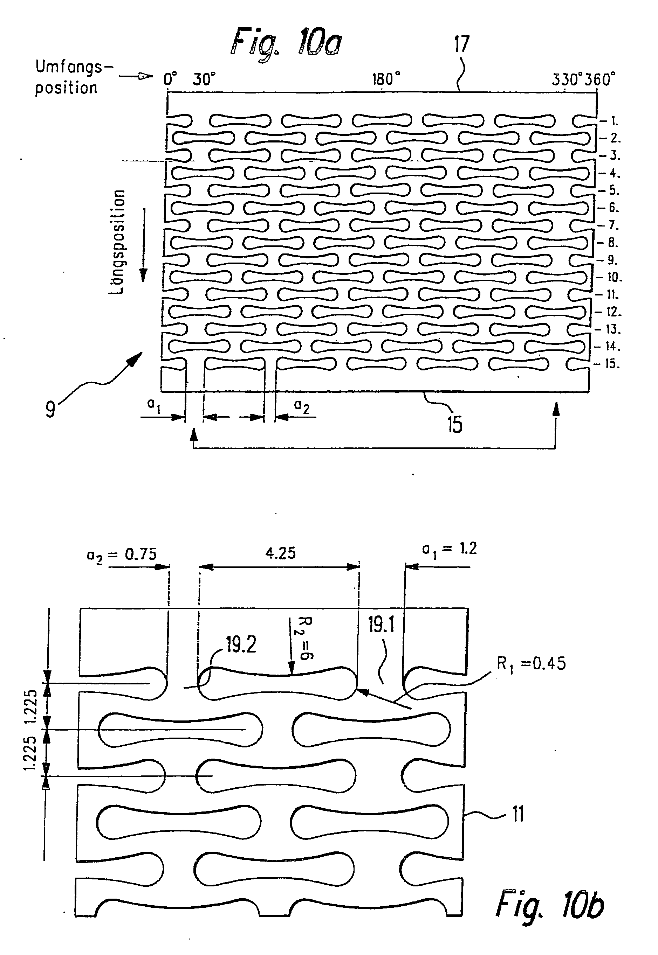

In Figur 10 ist ein weiteres Ausführungsbeispiel einer Platine 9 zur Herstellung eines erfindungsgemäßen Hohlkörpers 4 dargestellt. Dabei weist die Platine 9 gegenüber den bereits beschriebenen Platinen folgende Unterschiede auf:
Im Bereich der Kanten 15 und 17, entsprechend einem zweiten Ende und einem ersten Ende des Hohlkörpers 4 ist die Platine 9 nicht perforiert. Dadurch wird der Hohlkörper 7 im Bereich seines ersten Endes 17 und im Bereich seines zweiten Endes 15 versteift, was die Größe der Maxima 27 (siehe Figur 3, Figur 5 und Figur 9) verringert.

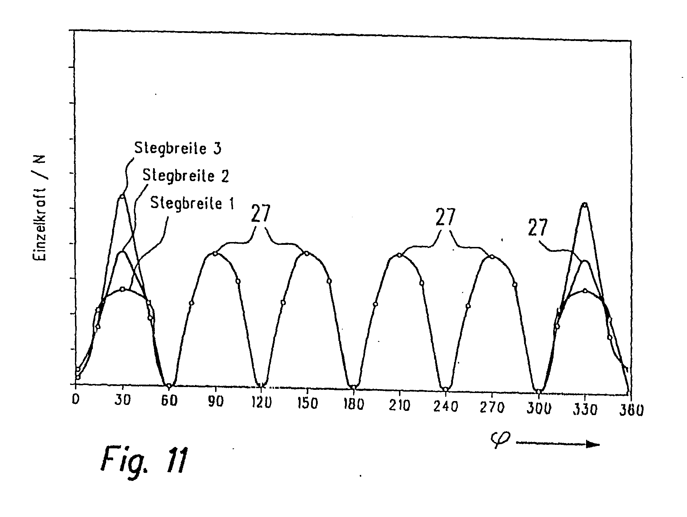

Eine zweite wesentliche Maßnahme zur Verbesserung des Hohlkörpers 4 besteht darin, dass die Breite a der Stege 19 individuell den auftretenden Belastungen angepasst wurde. So ist der Steg 19.1 in der ersten Reihe von Ausnehmungen 7, welcher sich in unmittelbarer Nähe der Kanten 11 und 13 befindet, breiter als ein Steg 19.2, welcher sich weiter entfernt von den Kanten 11 und 13 in der Platine befindet. Bei dem Ausführungsbeispiel beträgt die Breite a₁ des Stegs 19.1 in der Nähe der Kanten 11 und 13 1,2 mm, während die anderen Stege 19.2 eine Breite a₂ von nur 0,75 mm aufweisen. Je nach Dimensionierung der Stegbreiten a₁ und a₂ kann sogar eine Überkompensation der durch die Fuge 31 erfolgten Schwächung des Hohlkörpers 4 erfolgen. Dieser Effekt ist in der Figur 11, welche ein F-ϕ-Diagramm zeigt, dargestellt. Wenn der Stegabstand a₁ wie in Figur 10b gewählt wird, sind alle sechs Maxima 27 von gleichem Betrag. Diese Auslegung ist in Figur 10b durch den "Stegabstand aᵢ = 1, 2" dargestellt. Wenn die Stegbreite in unmittelbarer Nähe der Kanten 11 und 13 weiter erhöht wird, ist die Federrate des Hohlkörpers bei Umfangswinkeln ϕ = 30 ° und ϕ = 330 ° größer als in den Winkelbereichen dazwischen. Dies führt zu einer Überhöhung der Kurve im Bereich der Umfangswinkel 30 ° und 330 °, was in Figur 11 durch die Linie "Stegbreite 3" dargestellt ist.

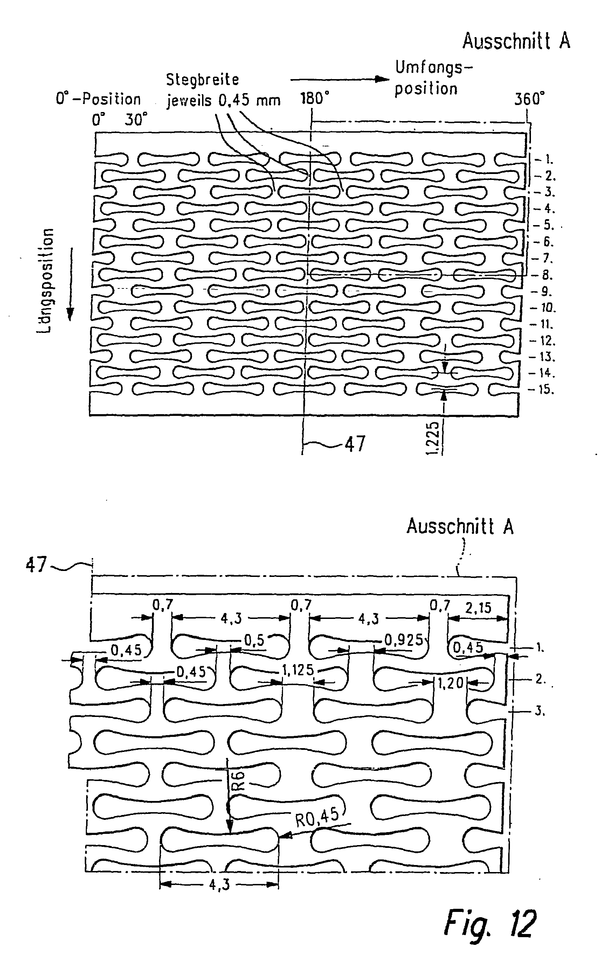

In Figur 12 ist ein weiteres Ausführungsbeispiel einer erfindungsgemäßen Platine 9 dargestellt, bei der die Stegbreiten individuell der Belastungssituation entsprechend festgelegt wurden. Die Platine 9 ist symmetrisch bezüglich einer Symmetrieachse 47, so dass die Bemaßung des Ausschnitts A, welche einen Quadranten der Platine 9 umfasst, durch Spiegeln eine vollständige Bemaßung der gesamten Platine 9 ergibt (nicht dargestellt). Auf das Einzeichnen der Bezugszeichen 7, R₁, R₂, L sowie 19, 21 und andere mehr wurde verzichtet, um die Übersichtlichkeit in Figur 12 nicht zu beeinträchtigen. Bezüglich der Figur 12 sei noch angemerkt, dass in der ersten Aussparungsreihe und in der 15. Aussparungsreihe gleiche Stegbreiten vorgesehen sind. Des Weiteren sind in der zweiten, vierten, sechsten, achten, zehnten und 14. Aussparungsreihe die Stegabstände gleich. Ebenso sind in der dritten, fünften, siebten, neunten, elften und 13. Aussparungsreihe die Stegbreiten gleich.

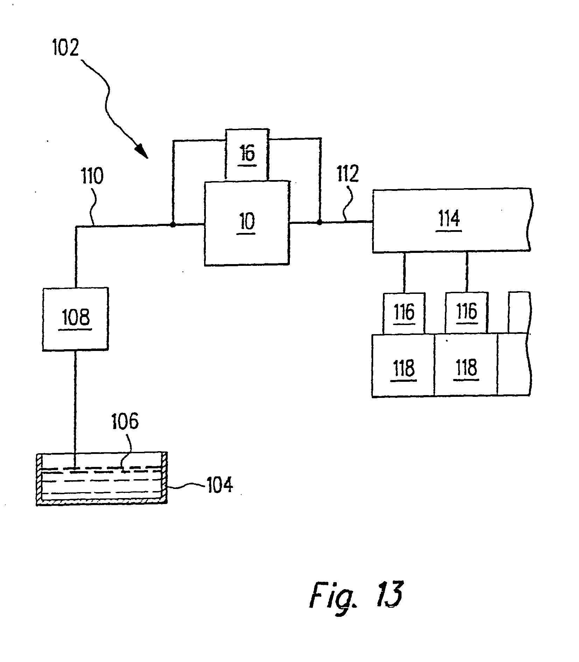

Anhand der Figur 13 wird nachfolgend erläutert, wie das erfindungsgemäße Kraftstoffeinspritzventil 116 in eine Kraftstoffeinspritzanlage 102 einer Brennkraftmaschine integriert ist. Die Kraftstoffeinspritzanlage 102 umfasst einen Kraftstoffbehälter 104, aus dem Kraftstoff 106 durch eine elektrische oder mechanische Kraftstoffpumpe 108 gefördert wird. Über eine Niederdruck-Kraftstoffleitung 110 wird der Kraftstoff 106 zu einer Hochdruck-Kraftstoffpumpe 111 gefördert. Von der Hochdruck-Kraftstoffpumpe 111 gelangt der Kraftstoff 106 über eine Hochdruck-Kraftstoffleitung 112 zu einem Common-Rail 114. An dem Common-Rail sind mehrere Kraftstoffeinspritzventile 116 angeschlossen, die den Kraftstoff 106 direkt in Brennräume 118 einer nicht dargestellten Brennkraftmaschine einspritzen.

## Patentansprüche

1. Aktoreinheit mit einem Hohlkörper (4) und mit einem piezoelektrischen Aktor (1), wobei der Hohlkörper (4) elastisch ausgebildet ist und den Aktor (1) vorspannt, wobei der Hohlkörper (4) mit Ausnehmungen versehen ist und eine parallel zu einer Längsachse (35) verlaufende Fuge (31) aufweist, wobei zwischen zwei benachbarten Ausnehmungen (7, 7a, 7b)) ein Steg (19) vorhanden ist, und wobei der Hohlkörper (4) ein erstes Ende (17) und ein zweites Ende (15) aufweist, **dadurch gekennzeichnet, dass** die zu der Fuge (31) benachbarten Ausnehmungen (7a, 7b) kleiner als die übrigen Ausnehmungen (7) sind.

2. Aktoreinheit mit einem Hohlkörper (4) und mit einem piezoelektrischen Aktor (1), wobei der Hohlkörper (4) elastisch ausgebildet ist und den Aktor (1) vorspannt, und wobei der Hohlkörper (4) mit Ausnehmungen versehen ist und eine parallel zu einer Längsachse (35) verlaufende Fuge (31) aufweist, wobei zwischen zwei benachbarten Ausnehmungen (7, 7a, 7b)) ein Steg (19) vorhanden ist, **dadurch gekennzeichnet, dass** der Steg (19.1) zwischen einer zu der Fuge (31) benachbarten Ausnehmung (7a, 7b) und einer zu dieser Ausnehmung benachbarten Ausnehmung (7) breiter als die Stege (19.2) zwischen den übrigen Ausnehmungen (7) ist.

3. Aktoreinheit nach Anspruch 2, **dadurch gekennzeichnet, dass** das Verhältnis der Breite eines Stegs (19.1) zwischen einer zu der Fuge (31) benachbarten Ausnehmung (7a, 7b) zu der Breite der übrigen Stege (19.2b) einen Wert zwischen 1,3 und 1,9, bevorzugt jedoch 1,6, hat.

4. Aktoreinheit nach Anspruch 2, **dadurch gekennzeichnet, dass** die Breite der Stege (19.1, 19.2) belastungsabhängig bemessen werden, und dass die Breite (a, a₁, a₂) der Stege (19) um bis zu einem Faktor 3 voneinander verschieden ist.

5. Aktoreinheit nach einem der vorhergehenden Ansprüche, **dadurch gekennzeichnet, dass** die Ausnehmungen (7) in mehreren Ebenen (Eᵢ) angeordnet sind, und dass die Ebenen (Eᵢ) parallel zueinander verlaufen.

6. Aktoreinheit nach Anspruch 5, **dadurch gekennzeichnet, dass** eine ungerade Zahl (i mit z. B. i = 11, 13, 15 oder 17)) von Ebenen (Eᵢ), in denen die Ausnehmungen (7) angeordnet sind, vorgesehen ist.

7. Aktoreinheit nach einem der vorhergehenden Ansprüche, **dadurch gekennzeichnet, dass** mehrere Ausnehmungen (7) in einer Ebene (E₂) hintereinander angeordnet sind, und dass die Ebene (E₂) mit der Längsachse (35) des Hohlkörpers (4) einen rechten Winkel bildet.

8. Aktoreinheit nach einem der vorhergehenden Ansprüche, **dadurch gekennzeichnet, dass** eine gerade Zahl von Ausnehmungen (7) in einer Ebene (E₂) vorhanden ist.

9. Aktoreinheit nach einem der vorhergehenden Ansprüche, **dadurch gekennzeichnet, dass** die Ausnehmungen (7) knochenförmig ausgebildet sind und quer zu einer Längsachse (35) des Hohlkörpers (4) verlaufen.

10. Aktoreinheit nach Anspruch 9, **dadurch gekennzeichnet, dass** die Ausnehmungen (7) aus einem Mittelstück (37) und zwei Kopfstücken (39) zusammengesetzt sind, dass die Kopfstücke (39) mindestens einen ersten Radius (R₁) aufweisen, dass das Mittelstück (37) einen zweiten Radius (R₂) aufweist, dass die Ausnehmungen (7, 7a, 7b) eine Länge (L) aufweisen, und dass für die Verhältnisse der im Innern der Platine angeordneten Ausnehmungen (7) zu den benachbart zu der Fuge (31) angeordneten Ausnehmungen (7a, 7b) gilt:
R₁ (7a, 7b) = 0,867 x R₁ (7)
R₂ (7a, 7b) = 1,317 x R₂ (7)
L (7a, 7b) = 0,984 x L (7)
Breite (b) eines halbierten Stegs (41) zur Fuge:
b > a/2; insbesondere b = 1,4 x a/2

11. Aktoreinheit nach Anspruch 9 oder 10, **dadurch gekennzeichnet, dass** die benachbart zur Fuge (31) angeordneten Ausnehmungen (7a, 7b) folgende Abmessungen haben:
R₁ (7a, 7b) = 0,35 mm bis 0,43 mm, insbesondere 0,39 mm
R₂ (7a, 7b) = 4,0 mm bis 8,9 mm, insbesondere 5,0 mm oder 7,9 mm
L (7a, 7b) = 3,5 mm bis 4,5 mm, insbesondere 4,0 mm

12. Aktoreinheit nach Anspruch 6 oder 7, **dadurch gekennzeichnet, dass** die benachbart zur Fuge (31) angeordneten Ausnehmungen (7a, 7b) folgende Abmessungen haben:
R₁ (7a, 7b) = 0,41 mm bis 0,49 mm, insbesondere 0,45 mm
R₂ (7a, 7b) = 5,5 mm bis 6,5 mm, insbesondere 6,0 mm
L (7a, 7b) = 3,7 mm bis 4,7 mm, insbesondere 4,2 mm

13. Aktoreinheit nach einem der Ansprüche 9 bis 12, **dadurch gekennzeichnet, dass** die Ausnehmungen (7) folgende Abmessungen haben:
R₁ (7) = 0,43 mm bis 0,51 mm, insbesondere 0,47 mm
R₂ (7) = 4,0 mm bis 4,8 mm, insbesondere 4,4 mm
L (7) = 4,5 mm bis 5,5 mm, insbesondere 5,0 mm

14. Aktoreinheit nach einem der Ansprüche 9 bis 13, **dadurch gekennzeichnet, dass** die Ausnehmungen (7) folgende Abmessungen haben:
R₁ (7) = 0,4 mm bis 0,5 mm, insbesondere 0,45 mm
R₂ (7) = 5,5 mm bis 6,5 mm, insbesondere 6,0 mm
L (7) = 4,0 mm bis 4,5 mm, insbesondere 4,255 mm

15. Aktoreinheit nach einem der vorhergehenden Ansprüche, **dadurch gekennzeichnet, dass** die ersten Radien der Kopfstücke (39) einer benachbart zu der Fuge (31) angeordneten Ausnehmung (7a, 7b) voneinander verschieden sind.

16. Aktoreinheit nach einem der vorhergehenden Ansprüche, **dadurch gekennzeichnet, dass** die Ausnehmungen (7) zweier benachbarter Ebenen (E₁) zueinander versetzt (23) angeordnet sind.

17. Aktoreinheit nach Anspruch 16, **dadurch gekennzeichnet, dass** der Versatz (23) der Ausnehmungen (7) zweier benachbarter Ebenen gleich dem halben Rapport (21) der Ausnehmungen (7) einer Ebene (E₁) ist.

18. Aktoreinheit nach einem der vorhergehenden Ansprüche, **dadurch gekennzeichnet, dass** der Hohlkörper (4) einen kreisrunden Querschnitt hat.

19. Aktoreinheit nach einem der vorhergehenden Ansprüche, **dadurch gekennzeichnet, dass** der Querschnitt des Hohlkörpers (4) die Form eines regelmäßigen Vielecks hat.

20. Aktoreinheit nach einem der vorhergehenden Ansprüche, **dadurch gekennzeichnet, dass** der Hohlkörper (4) an seinem ersten Ende (17) radial fixiert wird.

21. Aktoreinheit nach Anspruch 20, **dadurch gekennzeichnet, dass** der Hohlkörper (4) an seinem ersten Ende (17) radial in der oberen Abdeckplatte (6) oder einer Einstellscheibe (93), insbesondere durch eine Ringnut (39) oder einen Absatz, fixiert wird.

22. Aktoreinheit nach Anspruch 20, **dadurch gekennzeichnet, dass** der Hohlkörper (4) mit seinem ersten Ende (17) durch Schweissen (41) an der oberen Abdeckplatte (6) befestigt ist.

23. Aktoreinheit nach einem der vorhergehenden Ansprüche, **dadurch gekennzeichnet, dass** der Hohlkörper (4) an seinem zweiten Ende (15) radial fixiert wird.

24. Aktoreinheit nach einem der vorhergehenden Ansprüche, **dadurch gekennzeichnet, dass** der Hohlkörper (4) an seinem zweiten Ende (15) mit einer unteren Abdeckplatte (5) oder einem Kopplergehäuse (86) verbunden ist.

25. Aktoreinheit nach Anspruch 24, **dadurch gekennzeichnet, dass** der Hohlkörper (4) mit seinem zweiten Ende (15) durch Schweissen (41) an der unteren Abdeckplatte (5) oder dem Kopllergehäuse (86) befestigt ist.

26. Aktoreinheit nach einem der vorhergehenden Ansprüche, **dadurch gekennzeichnet, dass** der Hohlkörper (4) an seinem ersten Ende (17) und/oder an seinem zweiten Ende (15) einen nicht durch Ausnehmungen (7, 7a, 7b) perforierten Bereich aufweist.

27. Aktoreinheit nach einem der vorhergehenden Ansprüche, **dadurch gekennzeichnet, dass** der piezoelektrische Aktor (1) in dem Hohlkörper (4) angeordnet ist, und dass der piezoelektrische Aktor (1) durch den vorgespannten Hohlkörper (4) auf Druck belastet wird.

28. Aktoreinheit nach einem der vorhergehenden Ansprüche, **dadurch gekennzeichnet, dass** der piezoelektrische Aktor (1) außerhalb des Hohlkörpers (4) angeordnet ist, und dass der piezoelektrische Aktor (1) durch den vorgespannten Hohlkörper (4) auf Druck belastet wird.

## Claims

1. Actuating unit with a hollow body (4) and with a piezoelectric actuator (1), the hollow body (4) being elastically formed and prestressing the actuator (1), the hollow body (4) being provided with clearances and having a joint (31) running parallel to a longitudinal axis (35), a web (19) being present between two adjacent clearances (7, 7a, 7b), and the hollow body (4) having a first end (17) and a second end (15), **characterized in that** the clearances (7a, 7b) that are adjacent to the joint (31) are smaller than the other clearances (7).

2. Actuating unit with a hollow body (4) and with a piezoelectric actuator (1), the hollow body (4) being elastically formed and prestressing the actuator (1), and the hollow body (4) being provided with clearances and having a joint (31) running parallel to a longitudinal axis (35), a web (19) being present between two adjacent clearances (7, 7a, 7b), **characterized in that** the web (19.1) between a clearance (7a, 7b) that is adjacent to the joint (31) and a clearance (7) that is adjacent to this clearance is wider than the webs (19.2) between the other clearances (7).

3. Actuating unit according to Claim 2, **characterized in that** the ratio of the width of a web (19.1) between a clearance (7a, 7b) that is adjacent to the joint (31) and a clearance (7) that is adjacent to this clearance to the width of the other webs (19.2b) has a value between 1.3 and 1.9, but preferably 1.6.

4. Actuating unit according to Claim 2, **characterized in that** the width of the webs (19.1, 19.2) is made to correspond to the loading, and **in that** the width (a, a₁, a₂) of the webs (19) differs from web to web by up to a factor of 3.

5. Actuating unit according to one of the preceding claims, **characterized in that** the clearances (7) are arranged in a number of planes (Eᵢ), and **in that** the planes (Eᵢ) run parallel to one another.

6. Actuating unit according to Claim 5, **characterized in that** an uneven number (i, where for example i = 11, 13, 15 or 17) of planes (Eᵢ) in which the clearances (7) are arranged are provided.

7. Actuating unit according to one of the preceding claims, **characterized in that** a number of clearances (7) are arranged one behind the other in a plane (E₂), and **in that** the plane (E₂) forms a right angle to the longitudinal axis (35) of the hollow body (4).

8. Actuating unit according to one of the preceding claims, **characterized in that** there are an even number of clearances (7) in a plane (E₂).

9. Actuating unit according to one of the preceding claims, **characterized in that** the clearances (7) are of a bone-shaped form and run transversely in relation to a longitudinal axis (35) of the hollow body (4).

10. Actuating unit according to Claim 9, **characterized in that** the clearances (7) are made up of a middle piece (37) and two head pieces (39), **in that** the head pieces (39) have at least one first radius (R₁), and **in that** the middle piece (37) has a second radius (R₂), **in that** the clearances (7, 7a, 7b) have a length (L), and **in that** the following applies for the ratios of the clearances (7) that are arranged within the sheet to the clearances (7a, 7b) that are arranged adjacent to the joint (31):
R₁ (7a, 7b) = 0.867 × R₁ (7)
R₂ (7a, 7b) = 1.317 × R₂ (7)
L (7a, 7b) = 0.984 × L (7)
width (b) of a halved web (41) in relation to the joint:
b > a/2; in particular b = 1.4 × a/2.

11. Actuating unit according to Claim 9 or 10, **characterized in that** the clearances (7a, 7b) that are arranged adjacent to the joint (31) have the following dimensions:
R₁ (7a, 7b) = 0.35 mm to 0.43 mm, in particular 0.39 mm
R₂ (7a, 7b) = 4.0 mm to 8.9 mm, in particular 5.0 mm or 7.9 mm
L (7a, 7b) = 3.5 mm to 4.5 mm, in particular 4.0 mm.

12. Actuating unit according to Claim 6 or 7, **characterized in that** the clearances (7a, 7b) that are arranged adjacent to the joint (31) have the following dimensions:
R₁ (7a, 7b) = 0.41 mm to 0.49 mm, in particular 0.45 mm
R₂ (7a, 7b) = 5.5 mm to 6.5 mm, in particular 6.0 mm
L (7a, 7b) = 3.7 mm to 4.7 mm in particular 4.2 mm.

13. Actuating unit according to one of Claims 9 to 12, **characterized in that** the clearances (7) have the following dimensions:
R₁ (7) = 0.43 mm to 0.51 mm, in particular 0.47 mm
R₂ (7) = 4.0 mm to 4.8 mm, in particular 4.4 mm
L (7) = 4.5 mm to 5.5 mm, in particular 5.0 mm.

14. Actuating unit according to one of Claims 9 to 13, **characterized in that** the clearances (7) have the following dimensions:
R₁ (7) = 0.4 mm to 0.5 mm, in particular 0.45 mm
R₂ (7) = 5.5 mm to 6.5 mm, in particular 6.0 mm
L (7) = 4.0 mm to 4.5 mm, in particular 4.255 mm.

15. Actuating unit according to one of the preceding claims, **characterized in that** the first radii of the head pieces (39) of a clearance (7a, 7b) that is arranged adjacent to the joint (31) are different from one another.

16. Actuating unit according to one of the preceding claims, **characterized in that** the clearances (7) of two adjacent planes (E₁) are arranged offset in relation to one another (23).

17. Actuating unit according to Claim 16, **characterized in that** the offset (23) of the clearances (7) of two adjacent planes is equal to half the repeat (21) of the clearances (7) of a plane (E₁).

18. Actuating unit according to one of the preceding claims, **characterized in that** the hollow body (4) has a circular cross section.

19. Actuating unit according to one of the preceding claims, **characterized in that** the cross section of the hollow body (4) has the form of a regular polygon.

20. Actuating unit according to one of the preceding claims, **characterized in that** the hollow body (4) is radially fixed at its first end (17).

21. Actuating unit according to Claim 20, **characterized in that** the hollow body (4) is radially fixed at its first end (17) in the upper covering plate (6) or an adjusting washer (93), in particular by an annular groove (39) or a shoulder.

22. Actuating unit according to Claim 20, **characterized in that** the hollow body (4) is fastened with its first end (17) to the upper covering plate (6) by welding (41).

23. Actuating unit according to one of the preceding claims, **characterized in that** the hollow body (4) is radially fixed at its second end (15).

24. Actuating unit according to one of the preceding claims, **characterized in that** the hollow body (4) is connected at its second end (15) to a lower covering plate (5) or a coupler housing (86).

25. Actuating unit according to Claim 24, **characterized in that** the hollow body (4) is fastened with its second end (15) to the lower covering plate (5) or the coupler housing (86) by welding (41).

26. Actuating unit according to one of the preceding claims, **characterized in that** the hollow body (4) has at its first end (17) and/or at its second end (15) a region that is not perforated by clearances (7, 7a, 7b).

27. Actuating unit according to one of the preceding claims, **characterized in that** the piezoelectric actuator (1) is arranged in the hollow body (4), and **in that** the piezoelectric actuator (1) is compressively loaded by the prestressed hollow body (4).

28. Actuating unit according to one of the preceding claims, **characterized in that** the piezoelectric actuator (1) is arranged outside the hollow body (4), and **in that** the piezoelectric actuator (1) is compressively loaded by the prestressed hollow body (4).

## Revendications

1. Unité d'actionneur comprenant un corps creux (4) et un actionneur piézoélectrique (1), le corps creux (4) étant réalisé élastiquement et précontraignant l'actionneur (1), le corps creux (4) étant pourvu d'évidements et présentant un joint (31) s'étendant parallèlement à un axe longitudinal (35), une nervure (19) étant prévue entre deux évidements adjacents (7, 7a, 7b) et le corps creux (4) présentant une première extrémité (17) et une deuxième extrémité (15), **caractérisée en ce que** les évidements (7a, 7b) adjacents au joint (31) sont plus petits que les autres évidements (7).

2. Unité d'actionneur comprenant un corps creux (4) et un actionneur piézoélectrique (1), le corps creux (4) étant réalisé élastiquement et précontraignant l'actionneur (1), le corps creux (4) étant pourvu d'évidements et présentant un joint (31) s'étendant parallèlement à un axe longitudinal (35), une nervure (19) étant prévue entre deux évidements adjacents (7, 7a, 7b), **caractérisée en ce que** la nervure (19.1) entre un évidement (7a, 7b) adjacent au joint (31) et un évidement (7) adjacent à cet évidement est plus large que les nervures (19.2) entre les autres évidements (7).

3. Unité d'actionneur selon la revendication 2, **caractérisée en ce que** le rapport de la largeur d'une nervure (19.1) entre un évidement (7a, 7b) adjacent au joint (31) et un évidement (7) adjacent à cet évidement à la largeur des autres nervures (19.2b) a une valeur comprise entre 1,3 et 1,9, de préférence toutefois de 1,6.

4. Unité d'actionneur selon la revendication 2, **caractérisée en ce que** la largeur des nervures (19.1, 19.2) est dimensionnée en fonction des contraintes, et **en ce que** les largeurs (a, a₁, a₂) des nervures (19) sont différentes les unes des autres d'un facteur de 3 au maximum.

5. Unité d'actionneur selon l'une quelconque des revendications précédentes, **caractérisée en ce que** les évidements (7) sont disposés dans plusieurs plans (Eᵢ), et **en ce que** les plans (Eᵢ) s'étendent parallèlement les uns aux autres.

6. Unité d'actionneur selon la revendication 5, **caractérisée en ce qu'**un nombre impair (i avec par exemple i = 11, 13, 15 ou 17) de plans (Eᵢ) est prévu, dans lesquels sont disposés les évidements (7).

7. Unité d'actionneur selon l'une quelconque des revendications précédentes, **caractérisée en ce que** plusieurs évidements (7) sont disposés les uns derrière les autres dans un plan (E₂), et **en ce que** le plan (E₂) forme avec l'axe longitudinal (35) du corps creux (4) un angle droit.

8. Unité d'actionneur selon l'une quelconque des revendications précédentes, **caractérisée en ce qu'**un nombre pair d'évidements (7) est prévu dans un plan (E₂).

9. Unité d'actionneur selon l'une quelconque des revendications précédentes, **caractérisée en ce que** les évidements (7) sont réalisés en forme d'os et s'étendent transversalement à un axe longitudinal (35) du corps creux (4).

10. Unité d'actionneur selon la revendication 9, **caractérisée en ce que** les évidements (7) sont constitués d'une pièce centrale (37) et de deux parties de tête (39), **en ce que** les parties de tête (39) présentent au moins un premier rayon (R₁), **en ce que** la pièce centrale (37) présente un deuxième rayon (R₂), **en ce que** les évidements (7, 7a, 7b) présentent une longueur (L), et **en ce que** pour les rapports des évidements (7) disposés à l'intérieur de la platine aux évidements (7a, 7b) disposés à côté du joint (31), on a les relations suivantes :
R₁ (7a, 7b) = 0,867 x R₁ (7)
R₂ (7a, 7b) = 1,317 x R₂ (7)
L (7a, 7b) = 0,984 x L (7)
et pour la largeur (b) d'une demi-nervure (41) au joint : b > a/2 ; notamment b = 1,4 x a/2

11. Unité d'actionneur selon la revendication 9 ou 10, **caractérisée en ce que** les évidements (7a, 7b) disposés à côté du joint (31) ont les dimensions suivantes :
R₁ (7a, 7b) = 0,35 mm à 0,43 mm, notamment 0,39 mm
R₂ (7a, 7b) = 4,0 mm à 8,9 mm, notamment 5,0 mm ou 7,9 mm
L (7a, 7b) = 3,5 mm à 4,5 mm, notamment 4,0 mm.

12. Unité d'actionneur selon la revendication 6 ou 7, **caractérisée en ce que** les évidements (7a, 7b) disposés à côté du joint (31) ont les dimensions suivantes :
R₁ (7a, 7b) = 0,41 mm à 0,49 mm, notamment 0,45 mm
R₂ (7a, 7b) = 5,5 mm à 6,5 mm, notamment 6,0 mm
L (7a, 7b) = 3,7 mm à 4,7 mm, notamment 4,2 mm.

13. Unité d'actionneur selon l'une quelconque des revendications 9 à 12, **caractérisée en ce que** les évidements (7) ont les dimensions suivantes :
R₁ (7) = 0,43 mm à 0,51 mm, notamment 0,47 mm
R₂ (7) = 4,0 mm à 4,8 mm, notamment 4,4 mm
L (7) = 4,5 mm à 5,5 mm, notamment 5,0 mm

14. Unité d'actionneur selon l'une quelconque des revendications 9 à 13, **caractérisée en ce que** les évidements (7) ont les dimensions suivantes :
R₁ (7) = 0,4 mm à 0,5 mm, notamment 0,45 mm
R₂ (7) = 5,5 mm à 6,5 mm, notamment 6,0 mm
L (7) = 4,0 mm à 4,5 mm, notamment 4,255 mm.

15. Unité d'actionneur selon l'une quelconque des revendications précédentes, **caractérisée en ce que** les premiers rayons des parties de tête (39) d'un évidement (7a, 7b) disposé à côté du joint (31) sont différents les uns des autres.

16. Unité d'actionneur selon l'une quelconque des revendications précédentes, **caractérisée en ce que** les évidements (7) de deux plans adjacents (E₁) sont disposés de manière décalée (23) les uns par rapport aux autres.

17. Unité d'actionneur selon la revendication 16, **caractérisée en ce que** le décalage (23) des évidements (7) de deux plans adjacents est égal à la moitié du rapport (21) des évidements (7) d'un plan (E₁).

18. Unité d'actionneur selon l'une quelconque des revendications précédentes, **caractérisée en ce que** le corps creux (4) a une section transversale ronde circulaire.

19. Unité d'actionneur selon l'une quelconque des revendications précédentes, **caractérisée en ce que** la section transversale du corps creux (4) a la forme d'un polygone régulier.

20. Unité d'actionneur selon l'une quelconque des revendications précédentes, **caractérisée en ce que** le corps creux (4) est fixé radialement à sa première extrémité (17).

21. Unité d'actionneur selon la revendication 20, **caractérisée en ce que** le corps creux (4) est fixé radialement à sa première extrémité (17) dans la plaque de recouvrement supérieure (6) ou dans un disque d'ajustement (93), notamment par une rainure annulaire (39) ou un gradin.

22. Unité d'actionneur selon la revendication 20, **caractérisée en ce que** le corps creux (4) est fixé à sa première extrémité (17) par soudage (41) à la plaque de recouvrement supérieure (6).

23. Unité d'actionneur selon l'une quelconque des revendications précédentes, **caractérisée en ce que** le corps creux (4) est fixé radialement à sa deuxième extrémité (15).

24. Unité d'actionneur selon l'une quelconque des revendications précédentes, **caractérisée en ce que** le corps creux (4) est connecté à sa deuxième extrémité (15) à une plaque de recouvrement inférieure (5) ou à un boîtier d'accouplement (86).

25. Unité d'actionneur selon la revendication 24, **caractérisée en ce que** le corps creux (4) est fixé avec sa deuxième extrémité (15) par soudage (41) à la plaque de recouvrement inférieure (5) ou au boîtier d'accouplement (86).

26. Unité d'actionneur selon l'une quelconque des revendications précédentes, **caractérisée en ce que** le corps creux (4) présente, à sa première extrémité (17) et/ou à sa deuxième extrémité (15), une région non perforée par des évidements (7, 7a, 7b).

27. Unité d'actionneur selon l'une quelconque des revendications précédentes, **caractérisée en ce que** l'actionneur piézoélectrique (1) est disposé dans le corps creux (4), et **en ce que** l'actionneur piézoélectrique (1) est sollicité en pression par le corps creux précontraint (4).

28. Unité d'actionneur selon l'une quelconque des revendications précédentes, **caractérisée en ce que** l'actionneur piézoélectrique (1) est disposé en dehors du corps creux (4), et **en ce que** l'actionneur piézoélectrique (1) est sollicité en pression par le corps creux précontraint (4).
